# EUROPEAN PATENT APPLICATION

(11) **EP 4 123 625 A1**
(43) Date of publication of application: **25.01.2023**
(21) Application number: 21771210.8
(22) Date of filing: 02.03.2021
(51) Int. Cl.: G09F 9/30, H05B 33/02, H05B 33/06, H01L 51/50

(54) **LIGHT-EMITTING DEVICE**

(30) Priority: 17.03.2020 JP 2020046664
(71) Applicant: Kyocera Corporation, Kyoto-shi Kyoto 612-8501 (JP)
(72) Inventor: WATANABE, Masaya, Kyoto-shi, Kyoto 612-8501 (JP); NISHIDE, Masahiko, Kyoto-shi, Kyoto 612-8501 (JP); ARISAWA, Takashi, Kyoto-shi, Kyoto 612-8501 (JP); SUZUKI, Takanobu, Kyoto-shi, Kyoto 612-8501 (JP)
(74) Representative: TBK
(86) International application number: PCT/JP2021/007994
(87) International publication number: WO 2021/187090

(57) **Abstract**

A light-emitting device includes a substrate, a plurality of signal wires, a plurality of light emitter portions, and a plurality of lead wires. The plurality of signal wires is located on the substrate in a predetermined direction. The plurality of light emitter portions is located in line on the substrate in the predetermined direction. The plurality of lead wires is located on the substrate in a direction intersecting with the predetermined direction with an insulating layer between the plurality of lead wires and the plurality of signal wires. The plurality of lead wires connects the plurality of signal wires and the plurality of light emitter portions. At least half of the plurality of lead wires are included in varying-length areas in which the at least half of the plurality of lead wires have lengths varying in the predetermined direction.

## Description

### TECHNICAL FIELD

The present disclosure relates to a light-emitting device including a light emitter such as an organic light-emitting diode or an organic electroluminescence element.

### BACKGROUND OF INVENTION

A known light-emitting device is described in, for example, Patent Literature 1.

### CITATION LIST

### PATENT LITERATURE

Patent Literature 1: Japanese Unexamined Patent Application Publication No. 2017-216150

### SUMMARY

In one or more aspects of the present disclosure, a light-emitting device includes a substrate, a plurality of signal wires located on the substrate in a predetermined direction, a plurality of light emitter portions located in line on the substrate in the predetermined direction, and a plurality of lead wires located on the substrate in a direction intersecting with the predetermined direction with an insulating layer between the plurality of lead wires and the plurality of signal wires. The plurality of lead wires connects the plurality of signal wires and the plurality of light emitter portions. At least half of the plurality of lead wires are included in varying-length areas in which the at least half of the plurality of lead wires have lengths varying in the predetermined direction.

### BRIEF DESCRIPTION OF THE DRAWINGS

The objects, features, and advantages of the present disclosure will become more apparent from the following detailed description and the drawings.
FIG. 1 is a schematic plan view of a light-emitting device according to one embodiment of the present disclosure.
FIG. 2 is a schematic plan view of the light-emitting device illustrating its overall structure.
FIG. 3 is a circuit diagram of area III in FIG. 2 and a driver.
FIG. 4 is an enlarged partial plan view of light emitter portions and wires connected to the light emitter portions.
FIG. 5 is a cross-sectional view taken along line V1-V2 in FIG. 4.
FIG. 6 is a cross-sectional view taken along line V3-V4 in FIG. 1.

### DESCRIPTION OF EMBODIMENTS

The structure that forms the basis of a light-emitting device according to one or more embodiments of the present disclosure will be described. A known light-emitting device includes an elongated substrate having a main surface including multiple light emitters aligned in the longitudinal direction of the substrate, multiple drive circuit blocks for driving the corresponding light emitters, and multiple wires connecting the drive circuit blocks and the light emitters. The drive circuit blocks are aligned along the multiple light emitters that are aligned in line. Each drive circuit block drives the corresponding multiple light emitters. The substrate includes, on its one end or two ends in the longitudinal direction, a drive mounted with a mounting method such as COG (chip on glass). The drive drives each drive circuit block and each light emitter to control light emission from each light emitter. The substrate includes, at an edge portion near the drive on the main surface, a flexible printed circuit board for input and output of, for example, drive signals and control signals to and from the drive. Each drive circuit includes a shift register, a NOR (negated OR) circuit, an inverter, transfer gate elements, and drive TFTs (thin-film transistors). The drive TFTs each include a drain electrode connected to the light emitter including, for example, an OLED (organic light-emitting diode). In the light-emitting device, when each drive TFT receives a gate potential as a data signal at its gate electrode, a power supply current generated by a power supply voltage corresponding to the data signal is supplied to the corresponding light emitter, which then emits light with luminance corresponding to the data signal.

The known light-emitting device includes a multilayer stacked wiring structure with various wires between multiple insulating layers on the substrate. The multilayer stacked wiring structure includes lower-layer gate potential supply wires, which are electrically connected to the gate electrodes of the corresponding drive TFTs. The lower-layer gate potential supply wires extend near light-emitting points at which the corresponding light emitters are located and are connected to the corresponding upper-layer gate potential supply wires through interlayer connection conductors such as contact holes. The upper-layer gate potential supply wires extend in the lateral direction of the substrate and across the multiple lower-layer gate potential supply wires extending in the longitudinal direction of the substrate, and are connected to the gate electrodes of the corresponding drive TFTs.

The known light-emitting device has a parasitic capacitance between a single upper-layer gate potential supply wire and each of the multiple lower-layer gate potential supply wires. A different gate potential is fed to the gate electrode of each drive TFT due to the parasitic capacitance. In the known light-emitting device, each upper-layer gate potential supply wire is connected to the corresponding interlayer connection conductor at a connection. Each connection and the corresponding light-emitting point are spaced gradually farther from each other (or gradually nearer toward each other) over a proximal light-emitting point nearest a power supply at the longitudinal end of the substrate to a distal light-emitting point far from the power supply. The parasitic capacitance and resistance increase gradually over an upper-layer gate potential supply wire including the connection nearest the corresponding light-emitting point to an upper-layer gate potential supply wire including the connection farthest from the corresponding light-emitting point, causing gradient distributions of parasitic capacitance and resistance over the light-emitting points. Thus, the multiple light-emitting points emit light with a luminance gradient in the longitudinal direction. Thus, light-emitting devices with no gradient distributions of parasitic capacitance and resistance and less variations in luminance have been awaited.

A light-emitting device according to one or more embodiments of the present disclosure will now be described with reference to the accompanying drawings.

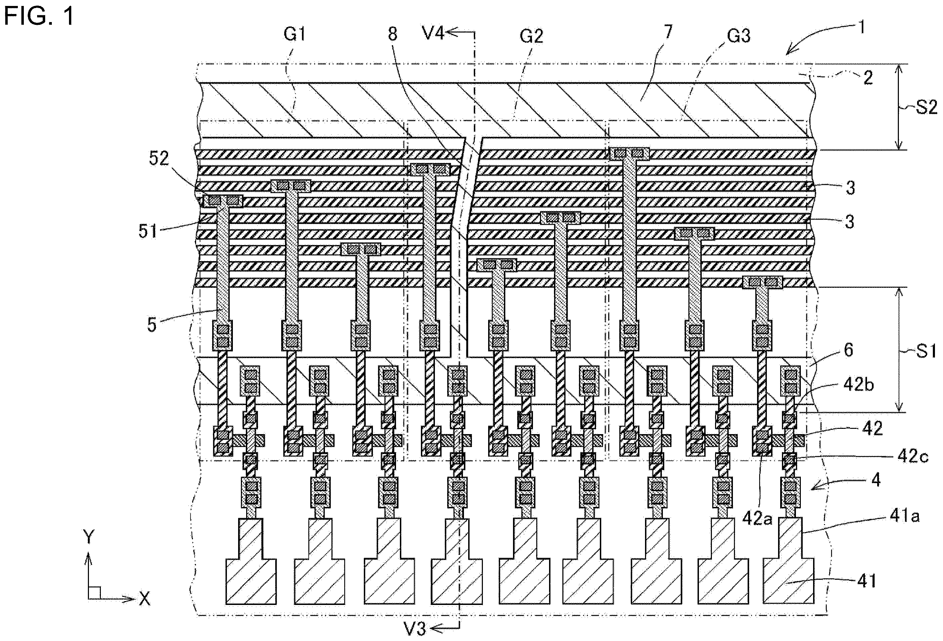

FIG. 1 is a schematic plan view of a light-emitting device according to one embodiment of the present disclosure. In the present embodiment, the light-emitting device included in an OLED printer head will be described as an example. The OLED printer head generates image information to form an electrostatic latent image on the surface of a photosensitive drum included in an imaging apparatus. The OLED printer head includes, for example, an elongated substrate on which multiple light-emitting blocks each including several hundred to several thousand light emitter portions are arranged in a predetermined circuit pattern. The light-emitting device according to one or more embodiments of the present disclosure has a basic circuit pattern described with reference to FIG. 1.

The light-emitting device according to one or more embodiments of the present disclosure includes a substrate 2, multiple signal wires 3, multiple light emitter portions 4, and multiple lead wires 5. The multiple signal wires 3 are located on the substrate 2 in a predetermined direction (e.g., in a longitudinal direction). The multiple light emitter portions 4 are located in line on the substrate 2 in the predetermined direction. The multiple lead wires 5 are located on the substrate 2 in a direction (e.g., in a lateral direction) intersecting with the predetermined direction with insulating layers between the lead wires 5 and the signal wires 3. The multiple lead wires 5 connect the multiple signal wires 3 and the corresponding light emitter portions 4. At least half of the multiple lead wires 5 are included in varying-length areas in which the at least half of the multiple lead wires 5 have lengths varying in the predetermined direction.

The light-emitting device according to one or more embodiments of the present disclosure has the above structure to produce the effects described below. Each varying-length area in which the lead wires 5 have varying lengths includes a varying number of intersections in the predetermined direction between the lead wire 5 and the signal wires 3 in a plan view. Thus, the resistance of the lead wires 5 and the parasitic capacitance generated at the intersections vary in the predetermined direction. This reduces the likelihood that the resistance of the lead wires 5 and the parasitic capacitance generated at the intersections gradually increase, causing gradient distributions of resistance and parasitic capacitance across the light emitter portions 4, and thus reduces the likelihood that the multiple light emitter portions 4 emit light with a luminance gradient in the longitudinal direction when receiving an input of the same amount of driving current.

Of multiple wire groups, 60% or more may include varying-length areas, 80% or more may include varying-length areas, or 100% may include varying-length areas. This further reduces the likelihood that the multiple light emitter portions 4 emit light with a luminance gradient in the longitudinal direction when receiving an input of the same amount of driving current.

The varying-length areas may be located consecutively or intermittently. The varying-length areas located consecutively may be located near a power supply voltage input unit. In areas near a power supply voltage output unit with a large voltage drop, the luminance is likely to decrease, and thus any luminance gradient in the longitudinal direction is less likely to be noticeable. The varying-length areas located intermittently may be located alternately with non-varying-length areas. In this case, the varying-length areas with the luminance likely to have a gradient in the longitudinal direction are less noticeable. In this case, a single varying-length area may be larger than an adjacent single non-varying-length area. Such non-varying-length areas with the luminance likely to have a gradient in the longitudinal direction are far less noticeable. A pattern of a single varying-length area larger than an adjacent single non-varying-length area may be repeated. Such non-varying-length areas with the luminance likely to have a gradient in the longitudinal direction are still far less noticeable.

The varying-length areas may be formed using, for example, pseudorandom numbers generated by a computer software program.

The substrate 2 may be made of a light-transmissive material such as glass or resin (plastic) or a light non-transmissive material such as ceramic and metal. The substrate 2 made of a light-transmissive material allows emission of light through its surface (e.g., back surface) opposite to the surface (e.g., front surface) on which the light emitter portions 4 are located. The substrate 2 may be a composite substrate including multiple substrates made of different materials stacked on one another. For example, the substrate 2 may be a composite substrate including a glass substrate and a resin substrate stacked on each other. The substrate 2 may be a flexible substrate made of, for example, resin.

The substrate 2 having an elongated shape such as a rectangular or a strip may have the predetermined direction being the longitudinal direction. In this case, the direction intersecting with the predetermined direction may be the lateral direction. The substrate 2 having a symmetrical shape with no longitudinal direction such as a square may have the predetermined direction being a direction along one side of the substrate 2 (e.g., a row direction), and the direction intersecting with the predetermined direction being a direction along another side adjacent to the side of the substrate 2 (e.g., column direction).

The multiple lead wires 5 are located with the insulating layers between the lead wires 5 and the signal wires 3. The signal wires 3 may be lower-layer gate potential supply wires. The lead wires 5 may be upper-layer gate potential supply wires. In this case, for example, the lead wires 5 each have an end opposite to the light emitter portion 4 connected to the signal wire 3 through an interlayer connection conductor, such as a through-hole. The lead wires 5 each have an end near the light emitter portion 4 connected to the gate electrode of the drive TFT. Each drive TFT has its source electrode connected to a power supply wire 6 (illustrated in FIG. 1), and its drain electrode connected to the corresponding light emitter portion 4.

In the light-emitting device according to one or more embodiments of the present disclosure, the multiple lead wires 5 are divided into multiple wire groups (e.g., G1, G2, and G3 in FIG. 1), each of which includes the lead wires 5, located consecutively in the predetermined direction. The structure may satisfy 1 ≤ M1/M2 < 2, where K (K is a natural number greater than or equal to 2) is the number of multiple signal wires 3, L (L is a natural number less than K) is the number of lead wires 5 included in each wire group, M1 is the average value per lead wire 5 of the number of intersections between the lead wires 5 in each wire group and the K signal wires 3, and M2 is the average value per lead wire 5 of the number of intersections between the K lead wires 5 and the K signal wires 3. In this case, the average value M1 per lead wire 5 of the number of intersections in each wire group differs from the average value M2 per lead wire 5 of the number of intersections in the entire multiple (K) light emitter portions 4 as well as approaches 1. Thus, the arrangement pattern of the intersections in the entire light emitter portions 4 differs from the arrangement pattern of the intersections in each wire group. The average value M2 of the number of intersections in the entire light emitter portions 4 is approximate to the average value M1 of the number of intersections in each wire group. This reduces the likelihood that the multiple light emitter portions 4 emit light with a luminance gradient in the longitudinal direction when the multiple light emitter portions 4 in the multiple wire groups receive an input of the same amount of driving current. This also reduces the likelihood that the average value of the luminance of the entire multiple light emitter portions 4 differs from the average value of the luminance of the light emitter portions 4 connected to the multiple wire groups when receiving an input of the same amount of driving current. At the ratio M1/M2 of 2 or greater, the multiple light emitter portions 4 receiving an input of the same amount of driving current can have a greater difference between the average value of the luminance of the entire multiple light emitter portions 4 and the average value of the luminance of the light emitter portions 4 connected to the multiple wire groups. This causes areas with a different luminance between them to be more noticeable.

The ratio M1/M2 may be more approximate to 1, may satisfy 1 ≤ M1/M2 ≤ 1.5, or may satisfy 1 ≤ M1/M2 ≤ 1.3. The ratio M1/M2 may be any other value.

The value of K may be 100 or greater, and L may be 5 or greater. When K is less than 100, the multiple lead wires 5 may not be divided into the multiple wire groups, but the varying-length area may be provided entirely. Similarly, when L is less than 5, the multiple lead wires 5 may not be divided into the multiple wire groups, but the varying-length area may be provided entirely. The value of K may be about 100 to 10000, and L may be about 5 to 100, but the ranges are not limited to these ranges. A range of values referred to herein as one value to another value intends to mean the two values being inclusive.

The substrate 2 may have multiple light-emitting blocks, each of which includes K light emitter portions 4 located in line in the predetermined direction. The multiple light-emitting blocks include the varying-length areas in a predetermined pattern common to the multiple light-emitting blocks. In this structure, for example, a single predetermined pattern may be generated using pseudorandom numbers generated by a computer software program, and the predetermined pattern may be commonly used for the multiple light-emitting blocks. This structure uses a predetermined pattern of a varying-length area commonly for the multiple light-emitting blocks. Such a predetermined pattern is easy to generate.

The substrate 2 may have multiple light-emitting blocks, each of which includes K light emitter portions 4 located in line in the predetermined direction. The multiple light-emitting blocks include the varying-length areas in predetermined patterns different from one another in the multiple light-emitting blocks. In this structure, for example, predetermined patterns may be generated differently for the multiple light-emitting blocks using pseudorandom numbers generated by a computer software program. This structure uses different predetermined patterns of varying-length areas for the multiple light-emitting blocks, thus advantageously allowing the multiple light-emitting blocks to have different luminance distributions when the light-emitting blocks receive an input of the same amount of driving current.

In the present embodiment, a light-emitting device 1 includes a substrate 2, K signal wires 3, K light emitter portions 4, and K lead wires 5. The value of K is herein a natural number greater than or equal to 2. For example, K may be several hundreds to several thousands. In FIG. 1, K is set to 9 for ease of illustration and explanation. The light-emitting device 1 may include K light emitters or may include K times the number of block light emitters.

The light-emitting device 1 includes a multilayer stacked wiring structure on a main surface of the substrate 2 (hereafter also simply referred to as being on the substrate). The multilayer stacked wiring structure includes various wires, such as the signal wires 3 and the lead wires 5, between multiple insulating layers.

The substrate 2 is elongated. As illustrated in, for example, FIG. 1, the substrate 2 has long sides in the longitudinal direction X and short sides in the lateral direction Y perpendicular to the longitudinal direction X. The substrate 2 may be made of glass or resin, and is light-transmissive.

The K signal wires 3 are located on the substrate 2 in the longitudinal direction X. The K signal wires 3 are located at intervals between adjacent signal wires 3 in the lateral direction Y

The K light emitter portions 4 are located in line on the substrate 2 in the longitudinal direction X. The K light emitter portions 4 may be located in one line in the longitudinal direction X or may be located in multiple lines in the longitudinal direction X. Each light emitter portion 4 includes a light emitter 41 and a TFT 42.

The light emitter 41 includes, for example, an OLED or an OEL (organic electroluminescence) element. The light emitter 41 includes an anode electrode 41a and a cathode electrode. The anode electrode 41a is connected to a drain electrode of the TFT 42. The cathode electrode is connected to a ground wire.

The TFT 42 may be a p-channel TFT or may be an n-channel TFT. The TFT 42 includes a gate electrode 42a, a source electrode 42b, and a drain electrode 42c. The gate electrode 42a is connected to one of the K signal wires 3. The source electrode 42b is connected to the power supply wire (first power supply wire 6 in FIG. 1). The drain electrode 42c is connected to the anode electrode 41a of the light emitter 41.

The K lead wires 5 are located on the substrate 2 in the lateral direction Y intersecting with the longitudinal direction X with insulating layers between the lead wires 5 and the signal wires 3. The K lead wires 5 connect the K signal wires 3 to the corresponding K light emitter portions 4. The longitudinal direction X and the lateral direction Y intersect with each other, and may be orthogonal to each other as illustrated in FIG. 1. The longitudinal direction X and the lateral direction Y may not be orthogonal to each other. The intersection angle between the longitudinal direction X and the lateral direction Y may be selected within a range from about 60 to 120°. The K lead wires 5 are located at intervals between adjacent lead wires 5 in the longitudinal direction X. Each lead wire 5 has one end (hereafter also referred to as a first end) 51 connected to one of the K signal wires 3 and the other end connected to one of the K light emitter portions 4. Each lead wire 5 intersects with or overlaps at least one of the K signal wires 3 in a plan view as illustrated in, for example, FIG. 1.

The signal wires 3 and the lead wires 5 are electrically insulated from each other with the insulating layers between the signal wires 3 and the lead wires 5 in the thickness direction (direction perpendicular to the page of FIG. 1) of the substrate 2. Thus, a parasitic capacitance is generated between signal wires 3 and lead wires 5 intersecting with the signal wires 3 in a plan view. A wiring structure in which the number of intersections between signal wires 3 and lead wires 5 (hereafter also simply referred to as an intersection number) increases or decreases monotonically in the longitudinal direction X may have gradient distributions of parasitic capacitance and resistance in the longitudinal direction X, thus causing the luminance of light emitted from the multiple light emitters 41 to have a gradient distribution (gradation). The gradation is particularly noticeable when data signals are transmitted to cause the multiple light emitters 41 to emit light with the same luminance.

In the light-emitting device 1, the K (nine in FIG. 1) lead wires 5 are divided into imaginary multiple wire groups G1, G2, and G3 located consecutively in the longitudinal direction X as illustrated in, for example, FIG. 1. Each wire group includes L (three in FIG. 1) lead wires 5. The multiple wire groups G1, G2, and G3 are to have the ratio M1/M2 with a standard deviation less than or equal to a predetermined value, where M1 is the average value per lead wire 5 of the number of intersections (intersection number) between the L lead wires 5 in each of the wire groups G1, G2, and G3 and the K signal wires 3, and M2 (= (K + 1)/2) is the average value per lead wire 5 of the number of intersections (intersection number) between the K lead wires 5 and the K signal wires 3. The value of L is a natural number less than K. The predetermined value is, for example, 0.6 or less. In the light-emitting device 1, the multiple wire groups G1, G2, and G3 have the ratio M1/M2 approximate to 1, which is the average value of the ratio M1/M2. In other words, in the light-emitting device 1, the number of intersections between the signal wires 3 and the lead wires 5, or more specifically, the parasitic capacitance generated between the signal wires 3 and the lead wires 5 is substantially uniform in the longitudinal direction X. The light-emitting device 1 can reduce the likelihood that the luminance has gradation resulting from gradient distributions of parasitic capacitance generated between the signal wires 3 and the lead wires 5.

The K lead wires 5 may be included in varying-length areas in which the lead wires 5 have their lengths varying in the longitudinal direction X. For example, at least one of the multiple wire groups may include a varying-length area. In other words, not all the K lead wires 5 are gradually longer or gradually shorter in the longitudinal direction X. This structure easily allows the ratio M1/M2 to have the standard deviation less than or equal to the predetermined value, or more specifically, to approach 1. At least half of the multiple wire groups may include varying-length areas. This structure more easily allows the ratio M1/M2 to have the standard deviation less than or equal to the predetermined value, or more specifically, to approach 1. All the multiple wire groups may include varying-length areas. This structure still more easily allows the ratio M1/M2 to have the standard deviation less than or equal to the predetermined value, or more specifically, to approach 1.

In the present embodiment, the light-emitting device 1 may include, on the substrate 2, multiple light-emitting blocks located in the longitudinal direction X, each of which includes K light emitter portions 4 located in line in the longitudinal direction X, and varying-length areas located in a predetermined pattern common to the multiple light-emitting blocks. In this case, for example, a single predetermined pattern may be generated using pseudorandom numbers generated by a computer software program, and the predetermined pattern may be used commonly for the multiple light-emitting blocks. This structure uses a predetermined pattern of a varying-length area commonly for multiple light-emitting blocks. Such a predetermined pattern is easy to generate.

In the present embodiment, the light-emitting device 1 may include, on the substrate 2, multiple light-emitting blocks located in the longitudinal direction X, each of which includes K light emitter portions 4 located in line in the longitudinal direction X, and varying-length areas located in different predetermined patterns in the multiple light-emitting blocks. In this case, for example, predetermined patterns may be generated differently for the multiple light-emitting blocks using pseudorandom numbers generated by a computer software program. This structure uses different predetermined patterns of varying-length areas for the multiple light-emitting blocks, thus allowing the multiple light-emitting blocks to have different luminance distributions when the light-emitting blocks receive an input of the same amount of driving current.

Although the nine lead wires 5 are divided into imaginary three wire groups G1, G2, and G3 in FIG. 1, the total number of lead wires 5 (specifically, the value of K) and the number of wire groups may be set as appropriate. For example, 120 lead wires 5 may be divided into ten wire groups, or 400 lead wires 5 may be divided into 16 wire groups.

To allow the ratio M1/M2 to have the standard deviation less than or equal to the predetermined value, for example, L lead wires 5 and L signal wires of the K signal wires 3 may be connected to each other to cause each of the wire groups G1, G2, and G3 to have the ratio M1/M2 with a standard deviation substantially equal to 1, which is a target value, when the K signal wires 3 are connected to the K lead wires 5. The wire groups G1, G2, and G3 may not have the ratio M1/M2 equal to the target value. The ratio M1/M2 may be any value approximate to the target value with the standard deviation less than or equal to the predetermined value.

To allow the ratio M1/M2 to have the standard deviation less than or equal to the predetermined value, combinations of connections between the K signal wires 3 and the K lead wires 5, or more specifically, the K lead wires 5 with lengths varying in the longitudinal direction X may be determined using pseudorandom numbers generated by a computer software program to cause the ratio M1/M2 to have the standard deviation less than or equal to the predetermined value when the K signal wires 3 are connected to the K lead wires 5.

The light-emitting device 1 may include the wire groups G1, G2, and G3 each including five or more lead wires 5 and having the ratio M1/M2 with a standard deviation less than or equal to 0.4. When the ratio M1/M2 has the standard deviation of 0.4 or less, the gradient parasitic capacitance in the multiple wire groups G1, G2, and G3 can be reduced effectively. When each of the wire groups G1, G2, and G3 includes five or more lead wires 5, the ration M1/M2 of each of the wire groups G1, G2, and G3 easily approaches 1, which is the target value, when the K signal wires 3 are connected to the K lead wires 5.

The light-emitting device 1 further includes the first power supply wire 6, a second power supply wire 7, and a connection wire 8.

The first power supply wire 6 is in a first area S1 between the K signal wires 3 and the K light emitter portions 4 on the substrate 2 in the longitudinal direction X. The first power supply wire 6 receives a power supply voltage (e.g., about 14 V) from an external source. The light emitter portions 4 are connected to the first power supply wire 6. In the present embodiment, as illustrated in, for example, FIG. 1, the source electrode 42b of each TFT 42 is connected to the first power supply wire 6. This causes an electric field corresponding to a gate potential supplied to the gate electrode 42a to be applied to the light emitter 41.

The second power supply wire 7 is in a second area S2 opposite to the first area S1 across the K signal wires 3 on the substrate 2 in the longitudinal direction X. Similarly to the first power supply wire 6, the second power supply wire 7 receives a power supply voltage (e.g., about 14 V) from an external source.

At least one connection wire 8 is located on the substrate 2 and connects the first power supply wire 6 and the second power supply wire 7. Thus, the power supply wiring has a larger total cross-sectional area and smaller resistance. This reduces variations in the power supply voltage in the longitudinal direction X of the substrate 2, thus stabilizing the power supply voltage. This further reduces the likelihood that the luminance of the multiple light emitters 41 has gradation.

The connection wire 8 may extend between adjacent lead wires 5 of the K lead wires 5. In other words, the connection wire 8 connects an intermediate portion of the first power supply wire 6 in the longitudinal direction X and an intermediate portion of the second power supply wire 7 in the longitudinal direction X. This effectively reduces variations in the power supply voltage in the longitudinal direction X of the substrate 2. This effectively reduces the likelihood that the luminance of the multiple light emitters 41 has gradation.

The connection wire 8 may be bent in a plan view as illustrated in, for example, FIG. 1. In this case, the connection wire 8 with a wide line width can be located between adjacent lead wires 5. This effectively reduces variations in the power supply voltage in the longitudinal direction X of the substrate 2. This effectively reduces the likelihood that the luminance of the multiple light emitters 41 has gradation.

The lead wires 5 may each include, at the first end 51 connected to the signal wire 3, a connection pad 52 extending in the longitudinal direction X as illustrated in, for example, FIG. 1. Thus, the connections between the lead wires 5 and the signal wires 3 have less connection resistance, and the parasitic capacitance of the lead wires 5 is less likely to weaken or decrease a signal voltage. This effectively reduces the likelihood that the luminance of the multiple light emitters 41 has gradation.

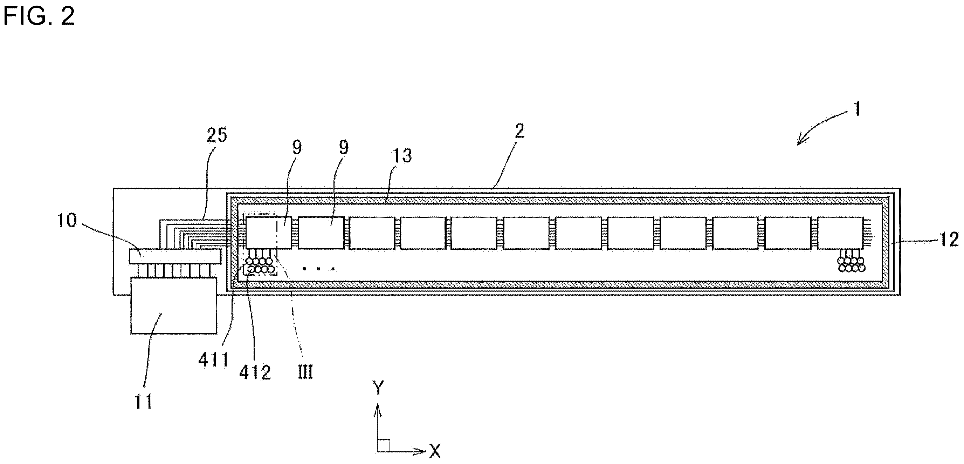

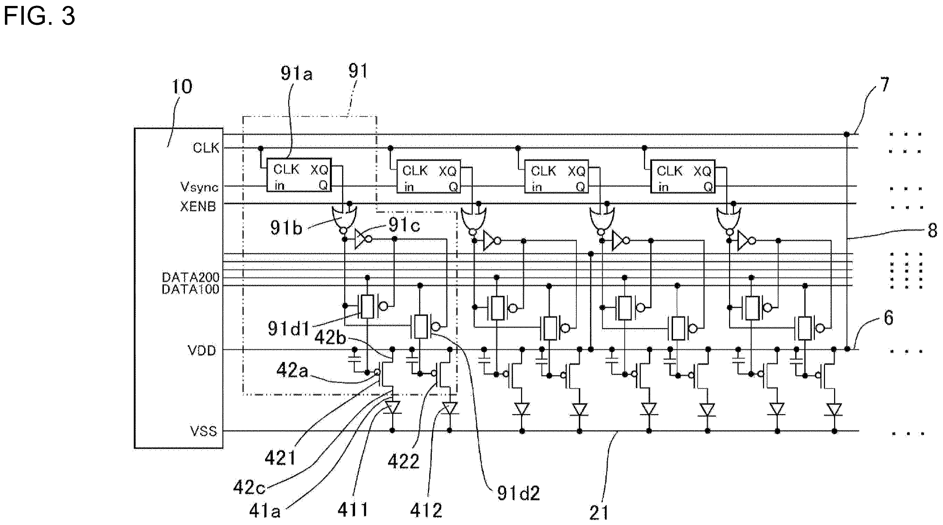

FIG. 2 is a schematic plan view of the light-emitting device illustrating its overall structure. FIG. 3 is a circuit diagram of area III in FIG. 2 and a driver. The light-emitting device 1 further includes multiple drive circuit blocks 9, a driver 10, and a flexible printed circuit board 11. The structures of the multiple drive circuit blocks 9, the driver 10, and the flexible printed circuit board 11 will now be described with reference to FIGs. 2 and 3.

The multiple drive circuit blocks 9 are located on the substrate 2 to drive the multiple light emitter portions 4. The multiple light emitter portions 4 are aligned in two lines in the longitudinal direction X as illustrated in, for example, FIG. 2. The substrate 2 includes wires in the drive circuit blocks 9 and wires for connecting the drive circuit blocks 9 and the light emitter portions 4 formed with a thin film formation method such as CVD (chemical vapor deposition).

The multiple drive circuit blocks 9 are arrayed in the longitudinal direction X. For example, when the light-emitting device 1 includes 8000 light emitter portions 4, and a single drive circuit block 9 drives 400 light emitter portions 4, 20 drive circuit blocks 9 are aligned in the longitudinal direction X. The substrate 2 includes, on one end of the main surface, the driver 10 for driving the drive circuit blocks 9 and the light emitter portions 4 to control light emission from the light emitters 41. The driver 10 is mounted on the substrate 2 with a mounting method such as COG. The flexible printed circuit board 11 is connected to an edge portion near the driver 10 on the main surface of the substrate 2. The flexible printed circuit board 11 allows input and output of, for example, drive signals and control signals into and from the driver 10. The wires such as data wires connecting the driver 10 and the drive circuit blocks 9 are illustrated collectively with reference numeral 25 in FIGs. 2 and 3.

The drive circuit block 9 includes multiple drive circuits 91. As illustrated in, for example, FIGs. 2 and 3, one drive circuit 91 drives two light emitters 411 and two light emitters 412 (also collectively referred to as the light emitter 41) aligned in two lines. Each drive circuit 91 includes a shift register 91a, a NOR circuit 91b, an inverter 91c, transfer gates 91d1 and 91d2, and TFTs 421 and 422 (also collectively referred to as the TFT 42) for driving. The transfer gates 91d1 and 91d2 are, for example, CMOS (complementary metal-oxide semiconductor) transfer gates and include an n-type MOS (metal-oxide-semiconductor) transistor and a p-type MOS transistor. The anode electrodes 41a of the light emitters 41 including OLEDs or OEL elements each are connected to the drain electrode 42c of the TFT 42.

Each drive circuit 91 operates sequentially as described below. Upon receiving a high-level (1) clock signal (CLK) at its clock terminal (CLK) and a high-level synchronization signal (Vsync) at its input terminal (in), the shift register 91a outputs a high-level signal from its output terminal (Q) and a low-level (0) signal from its inverting output terminal (XQ). Upon receiving the low-level signal from the inverting output terminal (XQ) and a low-level inverting enable signal (XENB), the NOR circuit 91b outputs a high-level signal.

Upon receiving the high-level signal, the inverter 91c outputs a low-level signal. The transfer gate 91d1 receives the high-level signal from the NOR circuit 91b at the gate electrode of its n-type MOS transistor and the low-level signal from the inverter 91c at the gate electrode of its p-type MOS transistor to be turned on, and outputs a data signal (DATA200). The data signal (DATA200) is input into the gate electrode 42a of the TFT 421, thus turning on the TFT 421. A power supply current corresponding to the data signal (DATA200) is supplied to the light emitter 411 from the power supply voltage.

The transfer gate 91d2 receives the high-level signal from the NOR circuit 91b at the gate electrode of its n-type MOS transistor and the low-level signal from the inverter 91c at the gate electrode of its p-type MOS transistor to be turned on, and outputs a data signal (DATA100). The data signal (DATA100) is input into the gate electrode 42a of the TFT 422, thus turning on the TFT 422. A power supply current corresponding to the data signal (DATA100) is supplied to the light emitter 412 from the power supply voltage.

The above sequence of operations is performed in order by subsequent drive circuits, causing all the light emitters 41 to emit light sequentially.

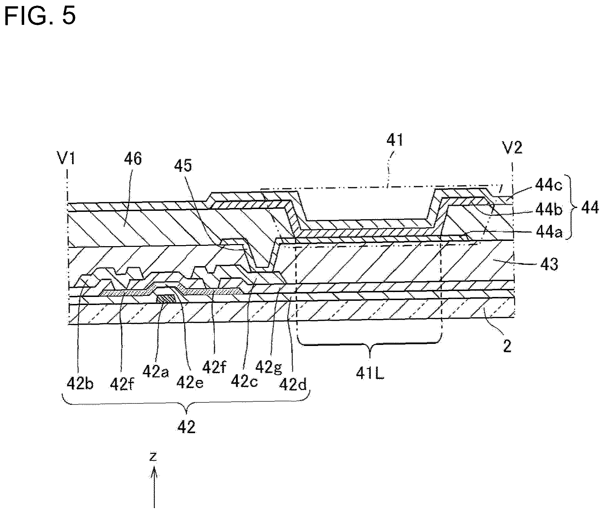

As illustrated in, for example, FIG. 2, the light-emitting device 1 further includes a sealing substrate 12 on the substrate 2. A seal 13 bonds and seals the periphery of the main surface of the substrate 2 and the periphery of a surface of the sealing substrate 12 facing the main surface of the substrate 2. The space inside the seal 13 may contain an insulating layer (corresponding to an insulating layer 46 in FIG. 5) made of acrylic resin or another material to cover most of the drive circuit blocks 9 and the wires 25.

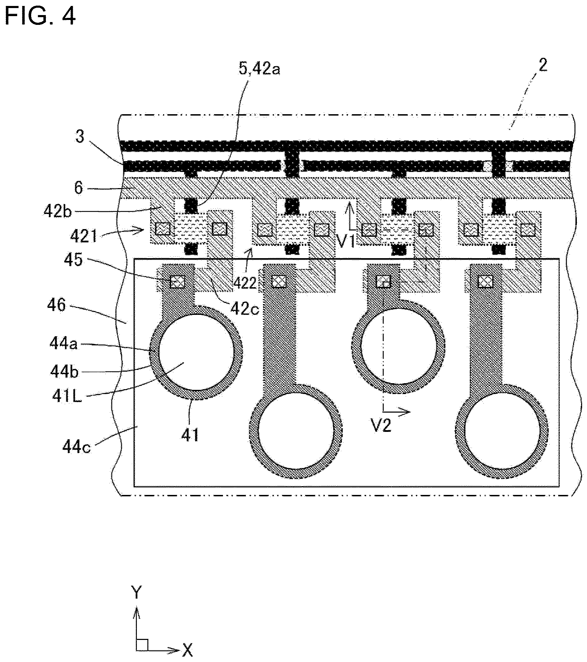

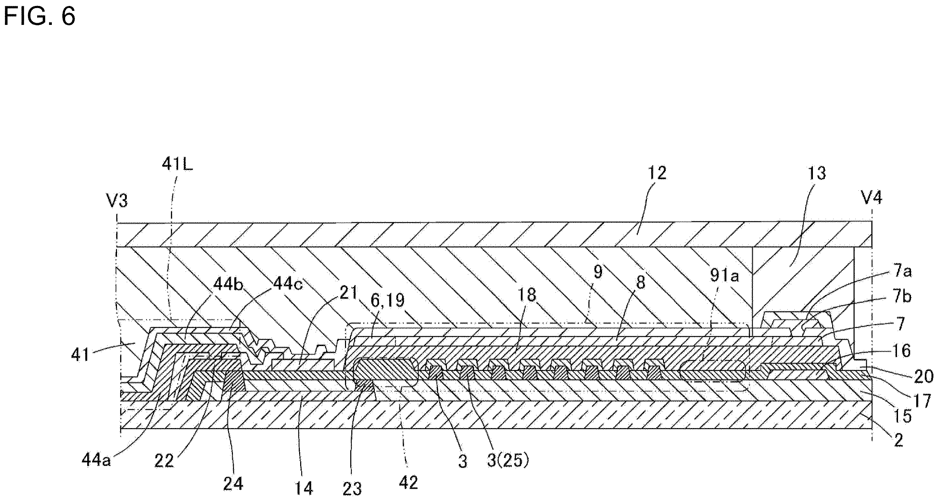

FIG. 4 is an enlarged partial plan view of the light emitter portions and the wires connected to the light emitter portions. FIG. 5 is a cross-sectional view taken along line V1-V2 in FIG. 4. FIG. 6 is a cross-sectional view taken along line V3-V4 in FIG. 1. The structure of the light emitter portion 4 will be described with reference to FIGs. 4 to 6.

As illustrated in, for example, FIGs. 4 and 5, the light emitter portion 4 may include the TFTs 421 and 422 (also collectively referred to as the TFT 42) on the substrate 2, organic emissive portions 44 stacked on the TFTs 421 and 422 with an insulating layer 43 made of acrylic resin, silicon nitride (SiNₓ), or another material between them, and contact holes 45 electrically connecting the organic emissive portions 44 and the drain electrodes 42c of the TFTs 42. Each organic emissive portion 44 includes a first electrode layer 44a electrically connected to the corresponding contact hole 45, an organic emissive layer 44b, and a second electrode layer 44c stacked in this order from the portion near the corresponding TFT 42. Another insulating layer 46 made of acrylic resin or another material is located on the insulating layer 43 and the first electrode layer 44a to surround the organic emissive layer 44b.

In FIGs. 4 and 5, a light-emitting portion 41L emits light when the first electrode layer 44a and the second electrode layer 44c apply an electric field directly to the organic emissive layer 44b. The light emitter 41 includes the light-emitting portion 41L, and the first electrode layer 44a and the organic emissive layer 44b around the light-emitting portion 41L in a plan view.

When the first electrode layer 44a is the anode being a transparent electrode made of, for example, ITO (indium tin oxide) and the second electrode layer 44c is the cathode made of metal or an alloy, such as Al, an Al-Li alloy, a Mg-Ag alloy (containing about 5 to 10 wt% of Ag), or a Mg-Cu alloy (containing 5 to 10 wt% of Cu), with a low work function of about 4.0 eV or lower and light-shielding and light-reflecting properties, light emitted at the organic emissive layer 44b is emitted through the substrate 2. In other words, the light-emitting direction is downward (in the negative Z-direction in FIG. 5), and the light-emitting device is a bottom-emission device.

When the first electrode layer 44a is the cathode made of metal with the light-shielding and light-reflecting properties described above or an alloy of such metals and the second electrode layer 44c is the anode being a transparent electrode, the light-emitting direction is upward (in the positive Z-direction in FIG. 5) and the light-emitting device is a top-emission device.

The TFT 42 includes, from the portion near the substrate 2, the gate electrode 42a, a gate insulating film 42d, a semiconductor film including a polysilicon film 42e as a channel and a high-concentration impurity area 42f made of polysilicon including a higher concentration of impurities than the channel, an insulating film 42g made of SiNₓ, silicon oxide (SiO₂), or another material, the source electrode 42b, and the drain electrode 42c stacked on one another in this order.

In FIG. 4, the first power supply wire 6 is a source signal wire (power supply wire) that transmits source signals (power supply current) to the source electrodes 42b of the TFTs 42. The signal wires 3 are gate signal wires that transmit gate signals to the gate electrodes 42a. The voltage of the gate signal input into each signal wire 3 is controlled to control the intensity of light emitted from the organic emissive layers. In other words, the first power supply wire 6 functions as a power supply wire (source signal wire).

As illustrated in, for example, FIG. 6, the substrate 2 includes, on the main surface, an anode connection wire 14 electrically connecting the drain electrode 42c of each TFT 42 and the first electrode layer (anode electrode in the example of FIG. 6) 44a of each light-emitting portion 41L, and a first interlayer insulating film 15 made of SiNₓ, SiO₂, or another material in this order.

The first interlayer insulating film 15 on which the wires 25 such as data wires for supplying a drive current to the organic emissive layer 44b and a ground wire 16 are located is covered with a second interlayer insulating film 17 made of SiNₓ, SiO₂, or another material. An insulating layer 18 (corresponding to the insulating layer 43 in FIG. 5) is located on the second interlayer insulating film 17 to cover the ground wire 16, the wires 25, and the TFTs 42.

The first power supply wire 6 as an anode power supply wire is located on the insulating layer 18. An anode wire 19 for feeding an anode current to the source electrodes 42b of the TFTs 42 is located in an area on the insulating layer 18 overlapping the TFTs 42 in a plan view. A protective insulating layer 20 covers the first power supply wire 6 and the anode wire 19. The protective insulating layer 20 is made of SiNₓ, SiO₂, or another material. FIG. 6 illustrates the drive circuit block 9 and the shift register 91a.

The seal 13 is located in a predetermined portion on the protective insulating layer 20, for example, in a peripheral portion on the protective insulating layer 20. The seal 13 hermetically seals the space between the substrate 2 and the sealing substrate 12. The seal 13 may be located in a peripheral portion on the protective insulating layer 20 overlapping the second power supply wire 7 in a plan view.

A cathode power supply wire 21 is located in an area on the second interlayer insulating film 17 overlapping the anode connection wire 14. An interlayer conductor layer 22 is located near the light emitter 41 to connect the anode connection wire 14 and the first electrode layer 44a. The anode connection wire 14 has one end near the TFT 42 having a first contact hole 23 connected to the drain electrode 42c of the TFT 42, and the other end near the light emitter 41 having a second contact hole 24 connected to the interlayer conductor layer 22.

The first electrode layer 44a covers an end of the protective insulating layer 20 near the light-emitting portion 41L. The organic emissive layer 44b is located on the first electrode layer 44a. The second electrode layer (cathode electrode in FIG. 6) 44c covers the organic emissive layer 44b. The second electrode layer 44c has one end in contact with the cathode power supply wire 21.

On the second power supply wire 7, an auxiliary power supply wire (also referred to as a power supply increasing wire) 7a is located parallel to the second power supply wire 7. The second power supply wire 7 and the auxiliary power supply wire 7a are connected to each other through a contact hole 7b. This structure substantially increases the cross-sectional area of the second power supply wire 7, reducing the electric resistance of the second power supply wire 7. Thus, the second power supply wire 7 shaped in a strip or a line in the longitudinal direction X of the substrate 2 being an elongated plate has a smaller voltage drop.

The light-emitting device 1 may include the multiple light emitter portions 4 aligned linearly in two lines of light emitter arrays, or may include the multiple light emitter portions 4 aligned linearly in four or six lines of light emitter arrays.

The light-emitting device 1 with the above structure including the multiple wire groups G1, G2, and G3 having the ratio M1/M2 with a standard deviation less than or equal to the predetermined value can reduce the likelihood that the luminance of the multiple light emitter portions 4 has gradation resulting from gradient distributions of parasitic capacitance and resistance generated between the signal wires 3 and the lead wires 5.

The light-emitting device 1 may include the K light emitter portions 4 including OLEDs or OEL elements. The OLEDs or the OEL elements can be directly formed on the substrate 2 as a thin light emitter portion 4 with a thin film formation method such as CVD or a film formation method such as an inkjet method. The K light emitter portions 4 may include chip-type light emitters such as LEDs (light-emitting diodes).

Although the embodiments of the present disclosure have been described in detail, the present disclosure is not limited to the embodiments described above, and may be changed or modified in various manners without departing from the spirit and scope of the present disclosure. The components described in the above embodiments may be entirely or partially combined as appropriate unless any contradiction arises.

### INDUSTRIAL APPLICABILITY

The light-emitting device according to one or more embodiments of the present disclosure may be an OLEDP (organic light-emitting diode printer) head with, for example, the multiple light emitters aligned in line in the longitudinal direction of the substrate 2 being an elongated plate. The light-emitting device may be an OEL display device with the multiple light emitters arranged in a two-dimensional (planar) manner on a substrate having the shape of, for example, a square or an elongated plate. The light-emitting device and the OEL display device according to one or more embodiments of the present disclosure may be used for various electronic devices. Such electronic devices include lighting apparatus, automobile route guidance systems (car navigation systems), ship route guidance systems, aircraft route guidance systems, indicators for instruments in vehicles such as automobiles, instrument panels, smartphones, mobile phones, tablets, PDAs (personal digital assistants), video cameras, digital still cameras, electronic organizers, electronic books, electronic dictionaries, personal computers, copiers, terminals for game devices, television sets, product display tags, price display tags, programmable display devices for industrial use, car audio systems, digital audio players, facsimile machines, printers, ATMs (automatic teller machines), vending machines, medical display devices, digital display watches, smartwatches, and guidance display devices installed in stations or airports.

### REFERENCE SIGNS

- 1: light-emitting device
- 2: sub strate
- 3: signal wire
- 4: light emitter portion
- 41, 411, 412: light emitter
- 41a 41L: light-emitting portion anode electrode
- 41b: cathode electrode
- 42, 421, 422: TFT (thin-film transistor)
- 42a: gate electrode
- 42b: source electrode
- 42c: drain electrode
- 42d: gate insulating film
- 42e: polysilicon film
- 42f: high-concentration impurity area
- 42g: insulating film
- 43: insulating layer
- 44: organic emissive portion
- 44a: first electrode layer
- 44b: organic emissive layer
- 44c: second electrode layer
- 45: contact hole
- 46: insulating layer
- 5: lead wire
- 51: one end (first end)
- 52: connection pad
- 6: first power supply wire
- 7: second power supply wire
- 7a: auxiliary power supply wire
- 7b: contact hole
- 8: connection wire
- 9: drive circuit block
- 91: drive circuit
- 91a: shift register
- 91b: NOR (negated OR) circuit
- 91c: inverter
- 91d1, 91d2: transfer gate
- 10: driver
- 11: flexible printed circuit board
- 12: sealing substrate
- 13: seal
- 14: anode connection wire
- 15: first interlayer insulating film
- 16: ground wire
- 17: second interlayer insulating film
- 18: insulating layer
- 19: anode wire
- 20: protective insulating layer
- 21: cathode power supply wire
- 22: interlayer conductor layer
- 23: first contact hole
- 24: second contact hole
- 25: wire

## Claims

1. A light-emitting device, comprising:
a substrate;
a plurality of signal wires located on the substrate in a predetermined direction;
a plurality of light emitter portions located in line on the substrate in the predetermined direction; and
a plurality of lead wires located on the substrate in a direction intersecting with the predetermined direction with an insulating layer between the plurality of lead wires and the plurality of signal wires, the plurality of lead wires connecting the plurality of signal wires and the plurality of light emitter portions,
wherein at least half of the plurality of lead wires are included in varying-length areas in which the at least half of the plurality of lead wires have lengths varying in the predetermined direction.

2. The light-emitting device according to claim 1, wherein
the plurality of lead wires is divided into a plurality of wire groups each including lead wires of the plurality of lead wires located consecutively in the predetermined direction, and
1 ≤ M1/M2 < 2, where K is the number of a plurality of signal wires, K is a natural number greater than or equal to 2, L is the number of lead wires included in each of the plurality of wire groups, L is a natural number less than K, M1 is an average value per lead wire of the number of intersections between the lead wires in each of the plurality of wire groups and the K signal wires, and M2 is an average value per lead wire of the number of intersections between the K lead wires and the K signal wires.

3. The light-emitting device according to claim 2, wherein
K is 100 or greater, and L is 5 or greater.

4. The light-emitting device according to claim 2 or claim 3, further comprising:
a plurality of light-emitting blocks located on the substrate in the predetermined direction, each of the plurality of light-emitting blocks including K light emitter portions located in line in the predetermined direction,
wherein the plurality of light-emitting blocks includes the varying-length areas in a predetermined pattern common to the plurality of light-emitting blocks.

5. The light-emitting device according to claim 2 or claim 3, further comprising:
a plurality of light-emitting blocks located on the substrate in the predetermined direction, each of the plurality of light-emitting blocks including K light emitter portions located in line in the predetermined direction,
wherein the plurality of light-emitting blocks includes the varying-length areas in predetermined patterns different from one another in the plurality of light-emitting blocks.

6. A light-emitting device, comprising:
an elongated substrate;
K signal wires located on the substrate in a longitudinal direction of the substrate, where K is a natural number greater than or equal to 2;
K light emitter portions located in line on the substrate in the longitudinal direction; and
K lead wires located on the substrate in a direction intersecting with the longitudinal direction with an insulating layer between the lead wires and the signal wires, the K lead wires connecting the K signal wires and the K light emitter portions,
wherein the K lead wires are divided into a plurality of wire groups each including L lead wires located consecutively in the longitudinal direction, where L is a natural number less than K, and
a ratio M1/M2 has a standard deviation less than or equal to a predetermined value, where M1 is an average value per lead wire of the number of intersections between the L lead wires in each of the plurality of wire groups and the K signal wires, and M2 is an average value per lead wire of the number of intersections between the K lead wires and the K signal wires.

7. The light-emitting device according to claim 6, wherein
each of the plurality of wire groups includes five or more lead wires, and
the predetermined value is 0.4.

8. The light-emitting device according to claim 6 or claim 7, wherein
the K lead wires are included in varying-length areas in which the K lead wires have lengths varying in the longitudinal direction.

9. The light-emitting device according to claim 8, wherein
at least half of the plurality of wire groups are included in the varying-length areas.

10. The light-emitting device according to claim 8 or claim 9, further comprising:
a plurality of light-emitting blocks located on the substrate in the longitudinal direction, each of the plurality of light-emitting blocks including the K light emitter portions located in line in the longitudinal direction,
wherein the plurality of light-emitting blocks includes the varying-length areas in a predetermined pattern common to the plurality of light-emitting blocks.

11. The light-emitting device according to claim 8 or claim 9, further comprising:
a plurality of light-emitting blocks located on the substrate in the longitudinal direction, each of the plurality of light-emitting blocks including the K light emitter portions located in line in the longitudinal direction,
wherein the plurality of light-emitting blocks includes the varying-length areas in predetermined patterns different from one another in the plurality of light-emitting blocks.

12. The light-emitting device according to any one of claims 6 to 11, further comprising:
a first power supply wire located in a first area on the substrate in the longitudinal direction, the first area being located between the K signal wires and the K light-emitting portions;
a second power supply wire located in a second area on the substrate in the longitudinal direction, the second area being located opposite to the first area across the K signal wires; and
at least one connection wire on the substrate, the at least one connection wire connecting the first power supply wire and the second power supply wire,
wherein the K light emitter portions are connected to the first power supply wire.

13. The light-emitting device according to claim 12, wherein
the at least one connection wire extends between adjacent lead wires of the K lead wires.

14. The light-emitting device according to claim 12 or claim 13, wherein
the at least one connection wire is bent in a plan view.

15. The light-emitting device according to any one of claims 6 to 14, wherein
each of the K lead wires includes a connection pad at an end connected to the corresponding signal wire, and
the connection pad extends in the longitudinal direction.

16. The light-emitting device according to any one of claims 1 to 15, wherein
the K light emitter portions include an organic light-emitting diode or an organic electroluminescence element.
